# EUROPEAN PATENT APPLICATION

(11) **EP 4 613 543 A1**
(43) Date of publication of application: **10.09.2025**
(21) Application number: 23884577.0
(22) Date of filing: 13.10.2023
(51) Int. Cl.: B60L 53/31, B60L 53/18, B60L 53/16, H01R 13/639

(54) **CABINET SIDE PLATE, CABINET COMPRISING CABINET SIDE PLATE, AND CHARGING DEVICE**

(30) Priority: 31.10.2022 CN 202222893655 U
(71) Applicant: Wuhan NIO Energy Co., Ltd., Wuhan, Hubei 430070 (CN)
(72) Inventor: LIN, Qun, Shanghai 201804 (CN); ZHUANG, Zhiqian, Shanghai 201804 (CN); XIA, Lijian, Shanghai 201804 (CN)
(74) Representative: Vossius & Partner Patentanwälte Rechtsanwälte mbB
(86) International application number: PCT/CN2023/124426
(87) International publication number: WO 2024/093645

(57) **Abstract**

A cabinet side plate (10) for fixing a liquid-cooled charging gun cable (20), a cabinet (70), and a charging device. The cabinet side plate (10) includes: a first through hole (101), which runs through the cabinet side plate (10) and allows the liquid-cooled charging gun cable (20) to pass through the first through hole (101); an inner-side locking attachment unit (102), which is configured on an inner side of the cabinet side plate (10) to restrict movement of the liquid-cooled charging gun cable (20) in a direction away from the cabinet side plate (10); and an outer-side locking attachment unit (103), which is configured on an outer side of the cabinet side plate (10) to restrict movement of the liquid-cooled charging gun cable (20) in the direction away from the cabinet side plate (10); where the first through hole (101), the inner-side locking attachment unit (102) and the outer-side locking attachment unit (103) jointly maintain a bend radius R of the liquid-cooled charging gun cable (20) passing through the first through hole (101) at 8D to 10D, D being an outer diameter of the liquid-cooled charging gun cable (20). Accordingly, a cabinet suitable for a high-power liquid-cooled charging gun cable is provided, which reduces damage to the high-power liquid-cooled charging gun cable caused by uncertain factors outside the cabinet such as excessive bending by an operator and unintentional collision and reduces installation space.

## Description

### Cross Reference to Related Application

The present application claims the priority to Chinese Patent Application No. CN202222893655.9 filed on October 31, 2022 and entitled "CABINET SIDE PLATE, CABINET COMPRISING CABINET SIDE PLATE, AND CHARGING DEVICE", which is incorporated herein by reference in its entirety.

### Technical Field

Embodiments of the invention relate to the technical field of charging, in particular to a cabinet side plate, a cabinet including the cabinet side plate, and a charging device.

### Technical Background

At present, a high-power charging gun cable on the market is generally locked and fastened to a housing of a cabinet by means of its own cable gland and is inserted perpendicularly or obliquely into the cabinet, which achieves both the fastening of the charging gun cable and the outdoor protection of the cabinet (As described in Chinese patents CN 202023146788.7, CN 202122048492.X, CN 201920907719.1, CN 201720367705.6 and CN 201720363878.0). However, this method is applicable to ordinary non-liquid-cooled charging gun cables, because they have low hardness, good flexibility, a large degree of bending and a small bend radius (generally 4D to 6D, D being the outer diameter of an ordinary non-liquid-cooled charging gun cable). However, when the method is applied to a high-power liquid-cooled charging gun cable having a liquid cooling pipe inside, there are many problems during use, because the liquid cooling pipe has a larger bend radius (generally 8D to 10D, D being the outer diameter of the liquid cooling pipe) which is more than twice that of the non-liquid-cooled charging gun cable. No matter whether the charging gun cable is inserted perpendicularly or obliquely and whether it is inside or outside the cabinet, the liquid cooling pipe needs to withstand a greater degree of bending to cause irreversible damage to the liquid cooling pipe, resulting in more serious dangers due to failure to dissipate heat promptly under high current. In addition, no matter whether the charging gun cable is inserted perpendicularly or obliquely, since the cable has a large bend radius, the cable protrudes more out of the cabinet, and thus occupies more extra space, resulting in a larger space required for product installation and a higher risk of damage caused by accidental touch.

Accordingly, there is an urgent need for a product that is suitable for a high-power liquid-cooled charging gun cable and requires a small installation space.

### Summary

In view of the foregoing problems, the invention provides a cabinet side plate and a cabinet including the cabinet side plate, which aim to overcome or at least partially solve the foregoing problems.

According to an embodiment of the invention, a cabinet side plate for fixing a liquid-cooled charging gun cable is provided. The cabinet side plate includes: a first through hole, which runs through the cabinet side plate and allows the liquid-cooled charging gun cable to pass through the first through hole; an inner-side locking attachment unit, which is configured on an inner side of the cabinet side plate to restrict movement of the liquid-cooled charging gun cable in a direction away from the cabinet side plate; and an outer-side locking attachment unit, which is configured on an outer side of the cabinet side plate to restrict movement of the liquid-cooled charging gun cable in the direction away from the cabinet side plate; where the first through hole, the inner-side locking attachment unit and the outer-side locking attachment unit jointly maintain a bend radius R of the liquid-cooled charging gun cable passing through the first through hole at 8D to 10D, D being an outer diameter of the liquid-cooled charging gun cable.

Optionally, the first through hole has a first dimension obtained based on a horizontal distance L1 between the inner-side locking attachment unit and the outer-side locking attachment unit, a horizontal distance L3 between the outer-side locking attachment unit and the cabinet side plate, and the bend radius R of the liquid-cooled charging gun cable.

Optionally, the first through hole is an obround hole, with an upper portion of the first through hole being arc-shaped.

Optionally, the inner-side locking attachment unit is arranged above the first through hole, and the outer-side locking attachment unit is arranged below the first through hole.

Optionally, the outer-side locking attachment unit includes a base and a fixing member movably connected to the base, and when the fixing member is connected to the base, a channel is formed to allow the liquid-cooled charging gun cable to pass through and restrict the movement of the liquid-cooled charging gun cable.

Optionally, the fixing member includes: a fixing portion, at least one second through hole being formed in each of the fixing portion and the base; a connecting portion, which is configured to pass through the second through holes of the fixing portion and the base to enable the fixing portion and the base to be fixed relatively; and a cambered extending portion, which is configured to form the channel with the base to allow the liquid-cooled charging gun cable to pass through and restrict the movement of the liquid-cooled charging gun cable.

Optionally, the cabinet side plate is further provided, on the inner side thereof, with two first ribs, which extend in a vertical direction and are respectively arranged at edges of the inner side of the cabinet side plate; and a second rib, which extends in a horizontal direction and is arranged between the two first ribs, and to which the base is locked and attached from the outer side of the cabinet side plate.

Optionally, the inner-side locking attachment unit includes a DC+/DC- copper busbar, and the liquid-cooled charging gun cable located at the inner side of the cabinet side plate is fixedly connected to the DC+/DC- copper busbar.

According to another aspect of the invention, a cabinet for fixing a liquid-cooled charging gun cable is further provided. The cabinet includes: a cabinet side plate described above; and a housing, which matches the first through hole and the outer-side locking attachment unit and is configured to cover the first through hole, the liquid-cooled charging gun cable and the outer-side locking attachment unit from the outside of the cabinet side plate.

Optionally, the housing is provided, on a side thereof facing the cabinet side plate, with: a first groove, which is configured to accommodate the liquid-cooled charging gun cable located on the outer side of the cabinet side plate; and a second groove, which is arranged at an outer edge of the housing and configured to be filled with a waterproof adhesive strip; where a plurality of columns and baffles are distributed and arranged between a wall of the first groove and a wall of the second groove.

Optionally, the cabinet further includes a decorative cover plate covering at least part of the housing from an outer side of the housing.

According to yet another aspect of the invention, a charging device is further provided. The charging device includes: a cabinet described above; and a charging gun, which includes a charging gun body and a liquid-cooled charging gun cable, the liquid-cooled charging gun cable entering the cabinet through the first through hole in the cabinet side plate.

As can be seen from the above technical solutions, according to the embodiment of the invention, the first through hole, the inner-side locking attachment unit and the outer-side locking attachment unit are provided on the cabinet side plate to maintain the bend radius R of the liquid-cooled charging gun cable at 8D to 10D, which enables the cabinet to be suitable for a high-power liquid-cooled charging gun cable, reduces damage to the high-power liquid-cooled charging gun cable caused by uncertain factors outside the cabinet such as excessive bending by an operator and unintentional collision, and reduces the installation space.

In addition, the inner-side locking attachment unit and the outer-side locking attachment unit ensure the locking of the liquid-cooled charging gun cable at upper and lower ends, and the liquid-cooled charging gun cable is in a freely bent state when passing through the first through hole, so as to ensure the liquid-cooled charging gun cable to be smoothly connected to the inner-side locking attachment unit and the outer-side locking attachment unit without other external stresses. Further, providing the first ribs and the second rib better disperses the force exerted on the outer-side locking attachment unit from the liquid-cooled charging gun cable or from the outside, such that the outer-side locking attachment unit can withstand greater force.

### Brief Description of Drawings

To describe technical solutions in embodiments of the invention or in the prior art more clearly, accompanying drawings required in description of the embodiments or in the prior art will be described briefly below. Apparently, the accompanying drawings in the following description merely show some embodiments described in the embodiments of the invention, and those of ordinary skill in the art would also derive other accompanying drawings from these accompanying drawings.
FIG. 1 is a partial schematic diagram of a cabinet according to an embodiment of the invention;
FIG. 2 is a partial schematic diagram showing an outer side of a cabinet side plate according to an embodiment of the invention;
FIG. 3 is a partial schematic diagram showing an inner side of a cabinet side plate according to an embodiment of the invention;
FIG. 4 is a schematic diagram of a method for determining dimensions of a first through hole according to the invention;
FIG. 5 is a schematic diagram of a base of an outer-side locking attachment unit according to an embodiment of the invention;
FIG. 6 is a schematic diagram of a fixing member of an outer-side locking attachment unit according to an embodiment of the invention;
FIG. 7 is a schematic diagram showing an inner side of a housing according to an embodiment of the invention;
FIG. 8 is a schematic diagram showing an outer side of a housing according to an embodiment of the invention;
FIG. 9 is a schematic diagram showing an inner side of a decorative cover plate according to an embodiment of the invention;
FIG. 10 is a schematic diagram showing an outer side of a decorative cover plate according to an embodiment of the invention;
FIG. 11 is a cross-sectional view of a cabinet side plate according to the invention after being assembled with a housing, a decorative cover plate and a liquid-cooled charging gun cable; and
FIG. 12 is a schematic diagram of a charging device according to an embodiment of the invention.

### Reference signs of elements:

10: cabinet side plate; 20: liquid-cooled charging gun cable; 101: first through hole; 102: inner-side locking attachment unit; 103: outer-side locking attachment unit; 1011: upper portion; 1012: lower portion; 1031: base; 1032: fixing member; 30: channel; 1033: fixing portion; 1034: second through hole; 1036: cambered extending portion; 104: first rib; 105: second rib; 1021: DC+/DC- copper busbar; 40: housing; 401: first groove; 402: second groove; 403: column; 404: baffle; 50: decorative cover plate; 60: charging gun; 1037: protruding rib; 1038: third through hole; 501: third rib; 405: positioning recess; 406: reset button mounting hole; 502: reset button; 407: third groove; 70: cabinet.

### Detailed Description of Embodiments

To enable those skilled in the art to better understand the technical solutions in the embodiments of the invention, the technical solutions in the embodiments of the invention will be clearly and completely described below in conjunction with the accompanying drawings in the embodiments of the invention. Apparently, the described embodiments are merely some, rather than all, of the embodiments of the invention. Based on the embodiments of the invention, all other embodiments obtained by those of ordinary skill in the art shall fall within the scope of protection of the embodiments of the invention.

In a "liquid-cooled charging gun cable" according to the invention, a liquid intake pipe, a liquid return pipe, a DC+ wire, a DC- wire, a charging gun signal cable, etc. are provided. For details, reference can be made to a cable structure of a charging gun in Chinese patent CN 202210980073.6. A "cabinet" as described usually forms a charging apparatus together with a charging gun. The charging gun can be locked and attached to or fitted outside the cabinet. One end of a liquid-cooled cable is connected to the charging gun, and the other end thereof is inserted into the cabinet. A liquid-cooling heat dissipation device, a display screen, electrical and control devices, etc. can be further optionally provided in the cabinet.

An "upper portion" and a "lower portion" of the first through hole as described respectively indicate the upper portion and the lower portion of the first through hole with reference to the paper where the diagram is located. The "above" or "below" as described indicates that one component is located "above" or "below" another component with reference to the paper where the diagram is located.

The specific implementation of the embodiments of the invention is further described below with reference to the accompanying drawings of the embodiments of the invention.

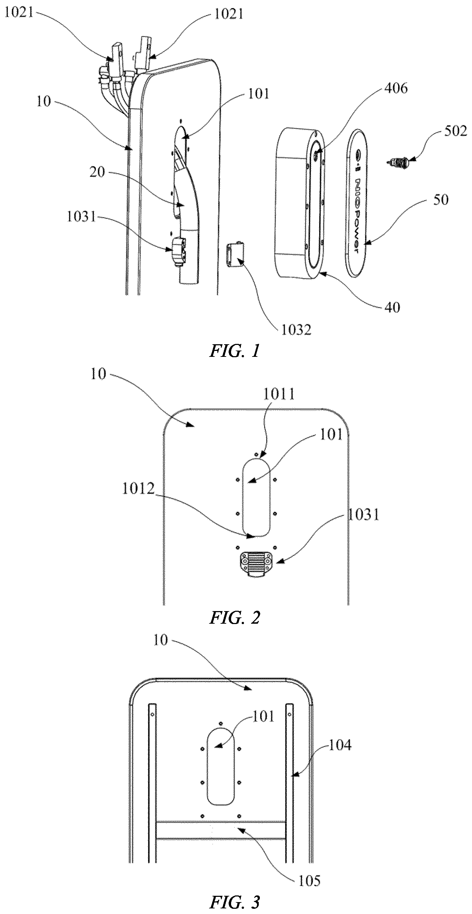

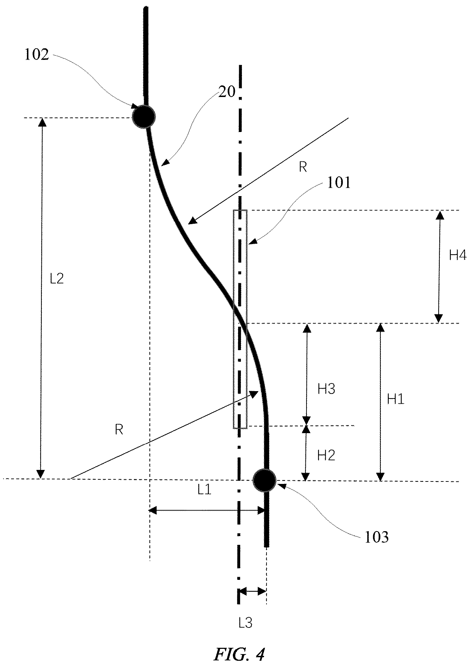

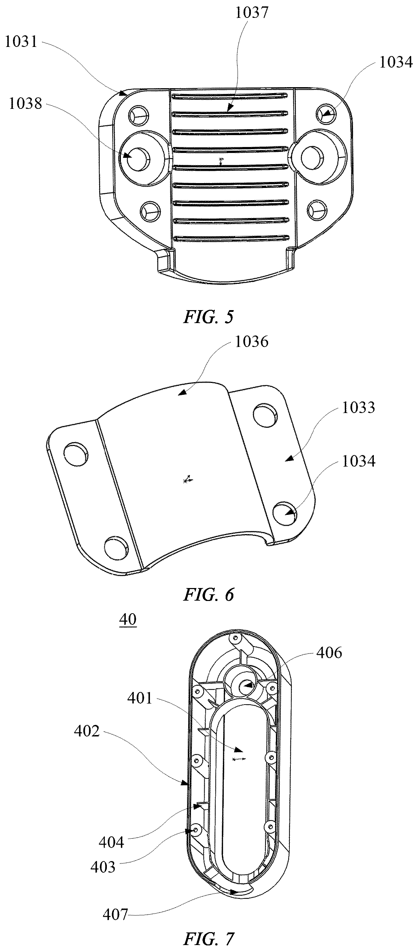

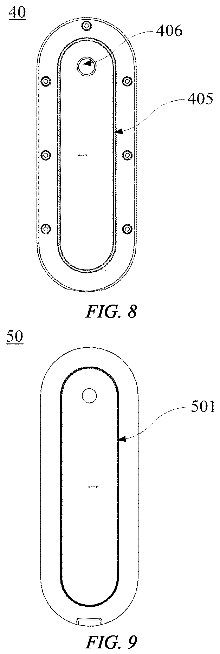

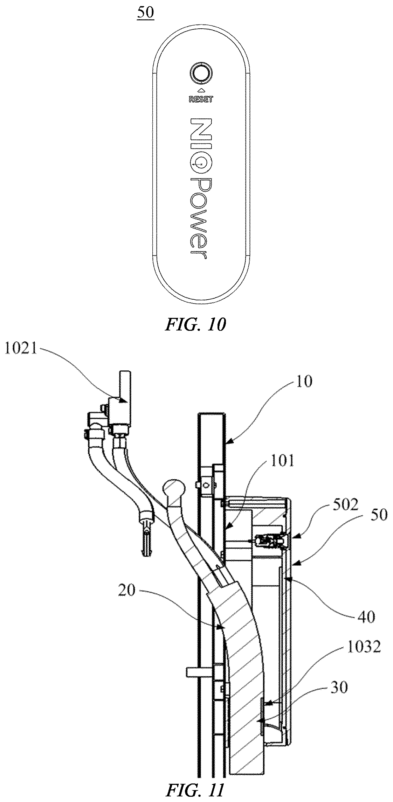

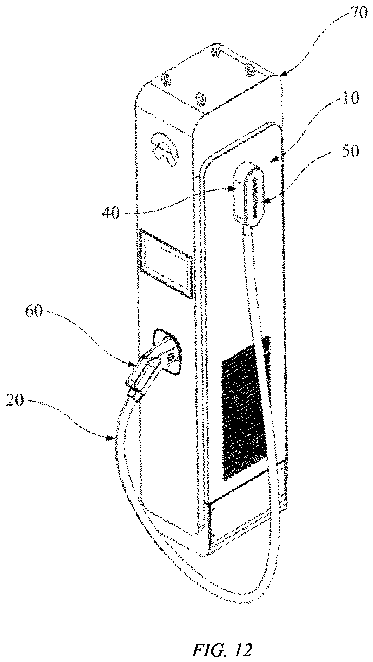

Referring to FIGS. 1A to 12, in a specific implementation of the invention, a cabinet side plate 10 is provided. The cabinet side plate includes: a first through hole 101, which runs through the cabinet side plate 10, allowing a liquid-cooled charging gun cable 20 to pass through the first through hole 101; an inner-side locking attachment unit 102, which is configured on an inner side of the cabinet side plate 10 to restrict movement of the liquid-cooled charging gun cable 20 in a direction away from the cabinet side plate 10; and an outer-side locking attachment unit 103, which is configured on an outer side of the cabinet side plate 10 to restrict movement of the liquid-cooled charging gun cable 20 in the direction away from the cabinet side plate 10. The first through hole 101, the inner-side locking attachment unit 102 and the outer-side locking attachment unit 103 jointly maintain a bend radius R of the liquid-cooled charging gun cable 20 passing through the first through hole 101 at 8D to 10D, D being the outer diameter of the liquid-cooled charging gun cable 20.

As shown in FIG. 1, the first through hole 101 may be an obround hole, that is, an upper portion 1011 of the first through hole 101 is arc-shaped, including semicircular or non-semicircular, a lower portion 1012 of the first through hole 101 may be horizontal, arc-shaped, or in other shapes, and two side edges between the upper portion 1011 and the lower portion 1012 are parallel to each other. The first through hole 101 is not limited to the obround hole, and may be in any other suitable shape.

In an embodiment of the invention, the first through hole 101 has first dimensions that are obtained based on a horizontal distance L1 between the inner-side locking attachment unit 102 and the outer-side locking attachment unit 103, a horizontal distance L3 between the outer-side locking attachment unit 103 and the cabinet side plate 10, and the bend radius R of the liquid-cooled charging gun cable 20. The first dimensions may include the width, the height, etc. of the hole. It is possible to first determine L1, L3 and R, draw a curve based on these values, and then calculate a vertical distance L2 between the outer-side locking attachment unit 103 and the inner-side locking attachment unit 102, a vertical distance H1 between a bent portion (i.e., the portion of the liquid-cooled charging gun cable 20 passing through the first through hole 101) and the outer-side locking attachment unit 103, etc. Further, it is possible to determine a vertical distance H3 of the liquid-cooled charging gun cable 20 bent on the outer side of the cabinet side plate 10, H2 (H2 = H1 - H3), and a vertical distance H4 between the upper portion 1011 of the first through hole 101 and the bent portion, and accordingly determine the height (H3 + H4) of the first through hole 101. The width of the first through hole 101 may be set according to the need for convenient assembly. For example, the width of the first through hole 101 may be 2D or other suitable values.

An example of a method for calculating the first dimensions is provided below. It is first determined that L1 = 110 mm, L3 = 25 mm, the outer diameter of the liquid-cooled cable D = 31.5 mm, and the bend radius R = 8 * D = 252 mm, the position of the inner-side locking attachment unit 102 may be limited by a copper busbar in the cabinet, and then it is calculated by solving based on a curve that L2 = 314.3 mm and H1 = 108 mm. Since H1 = H2 + H3, in order to leave enough space for assembly and take into account the requirement of waterproofing of a housing 40, it is designed based on practical operation experience and in a ratio of H3 : H2 = 2 : 1, that is, H3 = 72 mm, and H2 = 36 mm. To this end, the first through hole has an opening height of about H4 + H3 = 180 mm, and for ease of assembly, the first through hole may have an opening width of about 2D = 63 mm. The position of the outer-side locking attachment unit 103 may be determined based on a position of the base, that is, a vertical distance L2 between an upper portion of the base and the inner-side locking attachment unit 102 may be considered as L2 = 314.3 mm.

Optionally, the inner-side locking attachment unit 102 is arranged above the first through hole 101, and the outer-side locking attachment unit 103 is arranged below the first through hole 101.

In an embodiment of the invention, the inner-side locking attachment unit 102 includes a DC+/DC- copper busbar 1021, and the liquid-cooled charging gun cable 20 located on the inner side of the cabinet side plate 10 is fixedly connected to the DC+/DC- copper busbar 1021 for high-current power supply. The fixed connection may be implemented in various ways. For example, an end of the liquid-cooled charging gun cable 20 connected to the DC+/DC- copper busbar 1021 is made of metal and has a through hole, a screw is provided on the DC+/DC-copper busbar 1021, and the screw passes through the through hole of the liquid-cooled charging gun cable 20 and presses against the metal so as to enable the DC+/DC- copper busbar 1021 to be connected to the liquid-cooled charging gun cable 20.

First ribs 104 extending in a vertical direction may be provided at two edges of the inner side of the cabinet side plate 10, respectively, to ensure that the cabinet side plate 10 does not deform and to enhance the structural strength of the cabinet side plate 10. A second rib 105 extending in a horizontal direction may be provided between the two first ribs 104. The second rib 105 is not only configured to enhance the structural strength of the cabinet side plate 10, but also enables the outer-side locking attachment unit 103 on the outer side of the cabinet side plate 10 to be locked and attached to the second rib 105, so as to ensure that the force transmitted during stretching and twisting of the liquid-cooled charging gun cable 20 is completely borne by the outer-side locking attachment unit 103 and transmitted to and uniformly borne by the cabinet side plate 10, thereby preventing the cabinet side plate 10 from being seriously deformed due to local stress. The first ribs 104 and the second rib 105 may be fixed to the cabinet side plate 10 by means of welding or other methods. The second rib 105 may be fixedly connected to both the first ribs 104 by means of welding or other methods, or may not be connected to the first ribs.

In an embodiment, the outer-side locking attachment unit 103 includes a base 1031 and a fixing member 1032 movably connected to the base 1031, and when the fixing member 1032 is connected to the base 1031, a channel 30 is formed to allow the liquid-cooled charging gun cable 20 to pass through and restrict the movement of the liquid-cooled charging gun cable 20. The base 1031 may be made of aluminum or other materials.

In an embodiment, the fixing member 1032 includes: a fixing portion 1033, the at least one second through hole 1034 being formed in each of the fixing portion and the base 1031; a connecting portion, which is configured to pass through the second through holes 1034 of the fixing portion 1033 and the base 1031 to enable the fixing portion and the base to be fixed relatively; and a cambered extending portion 1036, which is configured to form the channel 30 with the base 1031 to allow the liquid-cooled charging gun cable 20 to pass through and restrict the movement of the liquid-cooled charging gun cable 20. The connecting portion may be a screw that is connected to both the second through holes 1034 so as to fix both the fixing member 1032 and the liquid-cooled charging gun cable 20 to the base 1031. The cambered extending portion 1036 may be C-shaped, U-shaped or in other shapes.

A protruding rib 1037 and a third through hole 1038 may be further provided on the base 1031. The base 1031 may be fixed to the second rib 105 from the outer side of the cabinet side plate 10 by means of connection of the third through hole 1038 and a screw. The protruding rib 1037 is configured to increase friction between the base 1031 and the liquid-cooled charging gun cable 20 to lock the liquid-cooled charging gun cable 20 more firmly. In addition, the liquid-cooled charging gun cable 20 may be locked through the interference fit among the base 1031, the fixing member 1032 and the liquid-cooled charging gun cable 20.

According to another aspect of the invention, a cabinet 70 for fixing the liquid-cooled charging gun cable 20 is further provided. The cabinet includes the cabinet side plate 10 described above and a housing 40. The housing 40 matches the first through hole 101 and the outer-side locking attachment unit 103 and is configured to cover the first through hole 101, the liquid-cooled charging gun cable 20 and the outer-side locking attachment unit 103 from the outside of the cabinet side plate 10. The housing 40 may be fixed to the cabinet side plate 10 by means of engagement of a through hole and a screw.

In an embodiment, the housing 40 is provided, on a side thereof facing the cabinet side plate 10, with: a first groove 401, which is configured to accommodate the liquid-cooled charging gun cable 20 located on the outer side of the cabinet side plate 10; and a second groove 402, which is arranged at an outer edge of the housing 40 and configured to be filled with a waterproof adhesive strip. A plurality of columns 403 and baffles 404 are distributed and arranged between a wall of the first groove 401 and a wall of the second groove 402. A third groove 407 may further be provided in a lower portion of the side of the housing 40 facing the cabinet side plate 10, so as to prevent the liquid-cooled charging gun cable 20 from being pressed when extending out of the housing 40 from the third groove 407. After extending out of the cabinet side plate 10 through the first through hole 101, the liquid-cooled charging gun cable 20 is bent in the first groove 401, then passes through the channel 30 formed by the base 1031 and the fixing member 1032 of the outer-side locking attachment unit 103, and extends out of the housing 40 through the third groove 407.

In an embodiment, the cabinet 70 further includes a decorative cover plate 50 covering at least part of the housing 40 from the outer side of the housing 40. A reset button mounting hole 406 may be further provided in the housing 40, a reset button 502 is provided on the decorative cover plate 50, and the reset button 502 is mounted in the reset button mounting hole 406. A third rib 501 may be further provided on the decorative cover plate 50, a positioning recess 405 is correspondingly provided in the housing 40, and the third rib 501 may be fitted in the positioning recess 405. The decorative cover plate may be further fixed by means of a double-sided adhesive tape or a screw.

According to another aspect of the invention, a charging device is further provided. The charging device includes the cabinet 70 described above and a charging gun 60. The charging gun 60 includes a charging gun body and the liquid-cooled charging gun cable 20, the liquid-cooled charging gun cable 20 entering the cabinet 70 through the first through hole 101 in the cabinet side plate 10.

Finally, it should be noted that the embodiments described above are merely used for illustrating rather than limiting the technical solutions of the embodiments of the invention. Although the invention has been illustrated in detail with reference to the foregoing embodiments, it should be understood by those of ordinary skill in the art that the technical solutions described in the foregoing embodiments may still be modified, or some of the technical features therein may be equivalently substituted, but these modifications or substitutions do not make the essence of corresponding technical solutions depart from the spirit and scope of the technical solutions of the embodiments of the invention.

## Claims

1. A cabinet side plate for fixing a liquid-cooled charging gun cable, the cabinet side plate comprising:
a first through hole, which runs through the cabinet side plate and allows the liquid-cooled charging gun cable to pass through the first through hole;
an inner-side locking attachment unit, which is configured on an inner side of the cabinet side plate to restrict movement of the liquid-cooled charging gun cable in a direction away from the cabinet side plate; and
an outer-side locking attachment unit, which is configured on an outer side of the cabinet side plate to restrict movement of the liquid-cooled charging gun cable in the direction away from the cabinet side plate;
wherein the first through hole, the inner-side locking attachment unit and the outer-side locking attachment unit jointly maintain a bend radius R of the liquid-cooled charging gun cable passing through the first through hole at 8D to 10D, D being an outer diameter of the liquid-cooled charging gun cable.

2. The cabinet side plate according to claim 1, wherein the first through hole has a first dimension obtained based on a horizontal distance L1 between the inner-side locking attachment unit and the outer-side locking attachment unit, a horizontal distance L3 between the outer-side locking attachment unit and the cabinet side plate, and the bend radius R of the liquid-cooled charging gun cable.

3. The cabinet side plate according to claim 1 or 2, wherein the first through hole is an obround hole, with an upper portion of the first through hole being arc-shaped.

4. The cabinet side plate according to claim 1, wherein the inner-side locking attachment unit is arranged above the first through hole, and the outer-side locking attachment unit is arranged below the first through hole.

5. The cabinet side plate according to claim 1 or 4, wherein the outer-side locking attachment unit comprises a base and a fixing member movably connected to the base, and when the fixing member is connected to the base, a channel is formed to allow the liquid-cooled charging gun cable to pass through and restrict the movement of the liquid-cooled charging gun cable.

6. The cabinet side plate according to claim 5, wherein the fixing member comprises:
a fixing portion, at least one second through hole being formed in each of the fixing portion and the base;
a connecting portion, which is configured to pass through the second through holes of the fixing portion and the base to enable the fixing portion and the base to be fixed relatively; and
a cambered extending portion, which is configured to form the channel with the base to allow the liquid-cooled charging gun cable to pass through and restrict the movement of the liquid-cooled charging gun cable.

7. The cabinet side plate according to claim 5, wherein the cabinet side plate is further provided, on the inner side thereof, with
two first ribs, which extend in a vertical direction and are respectively arranged at edges of the inner side of the cabinet side plate; and
a second rib, which extends in a horizontal direction and is arranged between the two first ribs, and to which the base is locked and attached from the outer side of the cabinet side plate.

8. The cabinet side plate according to claim 1 or 4, wherein the inner-side locking attachment unit comprises a DC+/DC- copper busbar, and the liquid-cooled charging gun cable located at the inner side of the cabinet side plate is fixedly connected to the DC+/DC- copper busbar.

9. A cabinet for fixing a liquid-cooled charging gun cable, the cabinet comprising:
a cabinet side plate according to any one of claims 1 to 8; and
a housing, which matches the first through hole and the outer-side locking attachment unit and is configured to cover the first through hole, the liquid-cooled charging gun cable and the outer-side locking attachment unit from the outside of the cabinet side plate.

10. The cabinet according to claim 9, wherein the housing is provided, on a side thereof facing the cabinet side plate, with
a first groove, which is configured to accommodate the liquid-cooled charging gun cable located on the outer side of the cabinet side plate; and
a second groove, which is arranged at an outer edge of the housing and configured to be filled with a waterproof adhesive strip;
wherein a plurality of columns and baffles are distributed and arranged between a wall of the first groove and a wall of the second groove.

11. The cabinet according to claim 9, wherein the cabinet further comprises a decorative cover plate covering at least part of the housing from an outer side of the housing.

12. A charging device, comprising:
a cabinet according to any one of claims 9-11; and
a charging gun, which comprises a charging gun body and a liquid-cooled charging gun cable, the liquid-cooled charging gun cable entering the cabinet through the first through hole in the cabinet side plate.
